# EUROPEAN PATENT SPECIFICATION

(11) **EP 3 257 055 B1**
(45) Date of publication and mention of the grant of the patent: **02.10.2019**
(21) Application number: 16706541.6
(22) Date of filing: 02.02.2016
(51) Int. Cl.: H01B 1/22, B29C 70/88, B29C 41/04, B29K 305/00, B29C 41/00, H05K 9/00, B29K 101/12, B29K 105/12

(54) **CONDUCTIVE PLASTIC PRODUCT**
LEITFÄHIGES KUNSTSTOFFPRODUKT
PRODUIT EN PLASTIQUE CONDUCTEUR

(30) Priority: 12.02.2015 EP 15154831
(43) Date of publication of application: 20.12.2017
(73) Proprietor: NV Bekaert SA, 8550 Zwevegem (BE)
(72) Inventor: LABRADO, Rafael, 9000 Gent (BE); VERSCHAEVE, Frank, 8553 Otegem (BE); DE BAERDEMAEKER, Jérémie, 8570 Anzegem (BE)
(74) Representative: Vangheluwe, Lieven Germain L.
(86) International application number: PCT/EP2016/052117
(87) International publication number: WO 2016/128246

(56) References cited:
- EP-A1- 2 597 120
- WO-A1-88/06342
- WO-A1-91/10701
- WO-A2-2014/048738
- GB-A- 1 201 166

## Description

### Technical Field

The invention relates to the field of electrically conductive plastic products, to a mixture for making such products; and to a method to make such products.

### Background Art

US4664971A discloses an electrically conductive plastic article containing electrically conductive fibers. The plastic article has shielding properties against electromagnetic interference and against radio-frequency. In order to obtain such an article, composite grains or granules with electrically conductive fibers are used as intermediary product. These composite grains are mixed with a predetermined amount of substantially pure plastic material and the blend is introduced in the hopper of an extruder of an injection moulding machine. The material is then heated to soften the plastic and worked to distribute the fibers in the plastic to obtain a plastic article with good shielding properties. WO 88/06342 A1 discloses an electrically conductive material for moulding.

Extrusion technology, including injection moulding, is not for all plastic articles an appropriate production technology. Rotational moulding - as e.g. described in WO2008/133535A1 - is a known technique for moulding plastics. EP 2 597 120 discloses a mixture for use in rotational moulding. Typically a heatable steel mould is partially filled with an appropriate amount of powdered plastics material, closed and heated while being rotated and tipped end to end. Powder contacting the heated inner walls of the mould will melt and fuse, sticking to the wall, and the combination of rotation and tipping ensures that the powder eventually contacts and coats every internal surface of the mould, making a continuous and complete plastic wall. The mould is then cooled and the plastic product can be removed out of the mould.

Rotational moulding has a number of benefits and is therefore favoured for a number of applications. Large parts can be made, and the mechanical properties of the plastic products are special and cannot be achieved by techniques such as injection moulding. Rotational moulding is an economical technique when a relatively small number of parts are required. Rotational moulding provides specific plastic products that are distinguished from other production technologies and recognizable by the mould separation zones in the product and by the structure of the plastic. Especially the inside of the plastic part, meaning the side that did not make contact with the outer mould during the rotational moulding operation, is specific in nature and structure.

It is known to add additives or fillers to the powdered plastic material used in rotational moulding. It is e.g. known to add reinforcing fibers, such as glass fiber or natural fiber, as is described in US2010/0129664A1. Such fiber additives have a length in the range of tenths of a millimetre.

For a range of applications, e.g. for protection against electrostatic discharge (ESD), electrical conductivity of plastic products is required. Today, no suitable electrically conductive plastic products made via rotational moulding are available.

### Disclosure of Invention

The primary objective of the invention is to provide an electrically conductive plastic product made via rotational moulding; and that can be made in a simple and reliable way.

A first aspect of the invention is an electrically conductive plastic product made via rotational moulding. The product comprises a plastic matrix; and a network of conductive fibers of discrete length embedded in the plastic matrix for providing electrical conductivity to the plastic product. The conductive fibers are metal fibers. The average length of the conductive fibers is at least 3 mm, preferably at least 5 mm, more preferably at least 8 mm, even more preferably at least 10 mm. In a preferred embodiment, the plastic matrix is a thermoplastic matrix.

A second aspect of the invention is a mixture for use in rotational moulding of electrically conductive plastic products. The mixture comprises a solid dispersion of conductive fibers of discrete length in a plastic powder (preferably a thermoplastic powder). Preferably, the plastic powder particles are spherical in shape. The conductive fibers are metal fibers. With solid dispersion is meant that the conductive fibers and the plastic powder are present in solid form; and the conductive fibers can individually move relative to all other conductive fibers in the mixture when the mixture is stirred at a temperature of 20°C, e.g. in a mixer. The conductive fibers of discrete length have an average length of at least 3 mm, preferably at least 5 mm, more preferably at least 8 mm, even more preferably at least 10 mm. The powder has a diameter of between 0.2 and 0.7 mm; e.g. between 0.3 and 0.5 mm. The mixture can comprise other additives, such as flame retardants, pigments, reinforcing fibers and processing agents. The weight percentage of the conductive fibers in the mixture is preferably between 0.1 and 20 %, more preferably between 5 and 20 %, even more preferably between 5 and 15 %. In a preferred embodiment, the average length of the conductive fibers is less than 25 mm, more preferably less than 20 mm and even more preferably less than 15 mm.

A third aspect of the invention is a method for producing an electrically conductive plastic product as in the first aspect of the invention via rotational moulding, comprising the steps of
- providing a mixture as in any embodiment of the second aspect of the invention;
- introducing the mixture in a mould;
- perform a rotational moulding operation with the mould to convert the mixture into an electrically conductive plastic product.
Preferably the mixture comprises the full amount of thermoplastic powder that will build the plastic matrix of the conductive plastic product.

It is well known to make electrically conductive plastic objects by means of injection moulding and by means of similar techniques using an extruder; and in which conductive fibers, e.g. stainless steel fibers, are used as conductive particles. As conductivity requires an even distribution of the conductive fibers in the plastic, mixing and blending of conductive fibers with the polymer is required. When an extruder is used, this is performed by means of pellets. Pellets are thermoplastic particles, comprising a certain amount of conductive fibers; the conductive fibers are embedded in the pellet. The pellets comprising the conductive fibers are made in a process starting directly or indirectly from a continuous fiber roving and a pultrusion process. It is a prerequisite for this process that the conductive fibers are available as a continuous fiber roving. Only a limited amount of metal fibers can be provided as continuous fiber roving, more specifically the metal fibers that can be manufactured by means of bundled drawing. Single end drawing - and subsequent bundling) would be possible as well, but is too expensive for the small diameters of fibers that are required. Such pellets are used as a master batch and fed into the extruder, together with plastic pellets. In the extruder screw(s) the polymer is melted and the materials are blended and mixed. A drawback is the breakage of the conductive fibers during extrusion and injection moulding. The shortening of the fibers results in lower electrical conductivity.

It is not possible to use the pellets comprising conductive metal fibers in rotational moulding. Rotational moulding requires the presence of the plastic in powder form. An intimate distribution of conductive fibers is required prior to the start of the rotary moulding process. The mixture of conductive metal fibers and plastic powder must be free flowing, to allow the rotary moulding processing. Surprisingly, the mixture of the second aspect of the invention has shown to have the free flowing properties that are required for use in rotational moulding. Use of this mixture has made it possible to produce the electrically conductive plastic product of the first aspect of the invention, e.g. via the method as described in the third aspect of the invention.

This way, the invention provides electrically conductive plastic products with properties hitherto not available, by overcoming the difficulties to produce such products.

A skilled person can without any doubt distinguish whether or not a plastic product has been manufactured via rotational moulding. E.g. the mould separation and the structure of the plastic (especially at the inside of the plastic part, meaning the side that did not make contact with the mould during the rotational moulding operation) are specific in nature and structure.

In a preferred conductive plastic product, the average length of the metal fibers is less than 25 mm, more preferably less than 20 mm and even more preferably less than 15 mm. Although the skilled person would select longer conductive fibers for better results in terms of conductivity of the electrically conductive plastic product, best results are obtained in rotational moulding of a conductive plastic product when the metal fibers in the mixture have an average length of less than 25 mm, more preferably less than 20 mm and even more preferably less than 15 mm.

Preferred for use in the invention are conductive fibers that are substantially uniform in length.

For use in the invention, preferred are conductive fibers that have a length over equivalent diameter ratio of less than 300, preferably less than 200; and more preferably less than 100. Preferred conductive fibers have a length over equivalent diameter ratio of at least 50. With equivalent diameter is meant the diameter of a fiber with circular cross section that has the same cross sectional area as the fiber concerned.

In preferred embodiments of the electrically conductive plastic product and/or of the mixture, the conductive fibers are machined metal fibers.

Preferred metal fibers for use in the invention are metal fibers that have a cross section that has two neighbouring straight lined sides with an included angle of less than 90° and one or more irregularly shaped curved sides. Preferably the standard deviation between fibers of the equivalent fiber diameter of such metal fibers is less than 25% of the equivalent fiber diameter. Such fibers can be made via machining from an ingot as is described in WO2014/048738A1. The cross sectional shape of the fibers is beneficial, as it helps to create an interconnecting network of conductive fibers in the plastic product. Preferably, the metal fibers are tapered along their length.

Preferred metal fibers for use in the invention are metal fibers out of a ferrous alloy, or metal fibers out of a non-ferrous metal or non-ferrous alloy. Examples of ferrous metals or alloys that can be used for the invention are e.g. stainless steel (e.g. AISI types such as 310L, 316L, 304, 430, 300-series, 400-series), Fe Cr Al Alloys (e.g. according to DIN 1.4767); Fe₃Al; Duplex steel types such as 1.4432, 1.4162, 1.4364, or 1.4410 (according to DIN standards), Super Duplex steel types; Nicrofer, Inconel 601 and Inconel HR.

Examples of non-ferrous metals and non-ferrous alloys that can be used are titanium, nickel, platinum, aluminium, copper, chromium, ... and alloys having a majority in weight percentage of the listed metals. An example of such an alloy is e.g. brass. Aluminium is a preferred choice as its heat conductivity has shown to facilitate the rotational moulding production process.

In preferred embodiments of the electrically conductive plastic product and/or of the mixture, the conductive fibers have a kidney or a banana shaped cross section. It is a benefit of this embodiment that such a fiber shape facilitates the formation of an interconnecting network of conductive fibers in the plastic product, contributing to the electrical conductivity of the product. The cross-sectional shape further facilitates the processing in rotational moulding, presumably by facilitating conduction of heat in the material during the production process. Examples of conductive fibers having a kidney or banana shaped cross sections are metal fibers that have been extracted out of the melt.

In a preferred electrically conductive plastic product and/or in a preferred mixture the conductive fibers have an equivalent diameter less than 100 µm, preferably less than 80 µm, more preferably less than 75 µm, more preferably less than 70 µm, even more preferably less than 50 µm. Preferably the conductive fibers have an equivalent diameter more than 5 µm, more preferably more than 10 µm.

In a preferred electrically conductive plastic product the weight percentage of the conductive fibers is between 0.1 and 20 %, preferably between 5 and 20 %, more preferably between 5 and 15 %.

Preferably the electrically conductive plastic product according to the first aspect of the invention is a double curved box or is a shell. Preferably, the wall thickness of the plastic product is between 2 and 10 mm, e.g. between 3 and 8 mm.

Preferably in the electrically conductive plastic product, the conductive fibers are present over the full wall thickness of the plastic product. In a more preferred embodiment, the conductive fibers are present over the full wall thickness of the plastic product, with a concentration of conductive fibers which is higher at the inside of the electrically conductive plastic product than at its outside.

Preferably, the amount of conductive fibers per unit of surface area of the plastic product is substantially constant over the full surface area of the plastic product.

As plastic powder in the mixture (and as plastic matrix in the electrically conductive plastic material), a whole range of plastics can be used, e.g. from the polyethylene family: cross-linked polyethylene (PEX), low-density polyethylene (LDPE), linear low-density polyethylene (LLDPE), high-density polyethylene (HDPE). Other possible plastics are PVC plastisols, polyamides, and polypropylene. Still other plastics that can be used are: polyvinylchloride, acrylonitrile butadiene styrene (ABS), acetal, acrylic, polyester, polybutylene, polyurethane and silicones. Preferred plastic powder has a mean particle size in the range of 0.1 to 1 mm, preferably in the range of 0.2 to 0.6 mm.

### Brief Description of the Drawings

Figure 1 shows the cross section of a metal fiber that can be used in the invention.
Figure 2 shows the cross section of an alternative metal fiber than can be used in the invention.
Figure 3 shows the cross section of an electrically conductive plastic product according to the first aspect of the invention.

### Mode(s) for Carrying Out the Invention

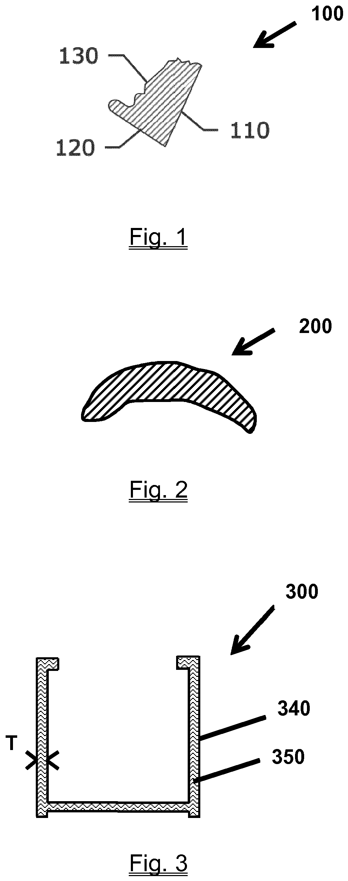

In order to make samples, machined aluminium fibers of 65 µm equivalent diameter and 5.5 mm length have been made. Alternative machined aluminium fibers of 35 µm equivalent diameter and 3 mm length have been made. Such fibers have a cross section as is shown in figure 1. The cross section 100 has two neighbouring straight lined sides 110, 120 with an included angle less than 90° and one or more irregularly shaped curved sides 130. The fibers had been made according to the method as described in WO2014/048738A1.

An alternative kind of metal fibers that can be used, are metal fibers extracted from the melt, having a kidney or banana cross sectional shape 200, as shown in figure 2.

The machined aluminium fibers have been mixed with polyethylene powder, in the weight ratios of 5 %, 10% and 17 % of fibers to the total weight of the mixture of plastic powder and fibers. Thereby, a solid dispersion of the aluminium fibers in the polyethylene powder has been obtained. The mixture has been made with standard blending equipment used in the rotomoulding industry to mix powder additives with the thermoplastic powder.

Plastics products have been made by means of rotational moulding, using these mixtures. Figure 3 shows the cross section 300 of boxes that have been made using rotational moulding. The products made had a wall thickness T of 4 mm. In the walls 340 of the box, a network of conductive fibers 350 of discrete length is embedded in the plastic matrix. The network of conductive fibers is created on the one hand thanks to the solid dispersion of conductive fibers and powder in the mixture, and on the other hand thanks to the rotational moulding process. The electrical conductivity has been measured on the outer surface of the plastic product. To this end, two circular probes with 5 mm diameter were used. One point on the plastic product was used as reference, and the electrical resistance was measured at several points on the outer surface of the plastic product relative to the reference point. The test results showed that the rotomoulded plastic products made had good conductivity levels (order of magnitude 10⁷ Ohm for the 5 % fiber weight ratio sample; order of magnitude 10³ - 10⁴ Ohm for the 10 % fiber weight ratio sample; order of magnitude 10³ Ohm for the 17 % fiber weight ratio sample), such that for all samples excellent protection against electrical discharge (ESD) is obtained.

## Claims

1. Electrically conductive plastic product made via rotational moulding, comprising
- a plastic matrix; and
- a network of conductive fibers of discrete length embedded in the plastic matrix for providing electrical conductivity to the plastic product,
wherein the conductive fibers are metal fibers; and
wherein the average length of the conductive fibers is at least 3 mm.

2. Electrically conductive plastic product as in any of the preceding claims, wherein the average length of the conductive fibers is less than 25 mm.

3. Electrically conductive plastic product as in any of the preceding claims, wherein the plastic matrix is a thermoplastic matrix.

4. Electrically conductive plastics product as any of the preceding claims, wherein the metal fibers are metal fibers out of a ferrous alloy, or are metal fibers out of a non-ferrous metal or alloy

5. Electrically conductive plastic product as in any of the claims 1 - 4, wherein the metal fibers have a cross section, wherein the cross section has two neighbouring straight lined sides with an included angle of less than 90° and one or more irregularly shaped curved sides.

6. Electrically conductive plastic product as in claims 1 - 4, wherein the metal fibers have a kidney or a banana shaped cross section.

7. Electrically conductive plastic product as in any of the preceding claims, wherein the metal fibers have an equivalent diameter less than 100 µm.

8. Electrically conductive plastic product as in any of the preceding claims, wherein the metal fibers have a length over equivalent diameter ratio of less than 300.

9. Electrically conductive plastic product as in any of the preceding claims,
wherein the weight percentage of the conductive fibers in the plastic product is between 0.1 and 20 %.

10. Mixture for use in rotational moulding of electrically conductive plastic products, wherein the mixture comprises a solid dispersion of conductive fibers of discrete length in a plastic powder;
wherein the plastic powder has a diameter between 0.2 and 0.7 mm;
wherein the conductive fibers are metal fibers and
wherein the conductive fibers have an average length of at least 3 mm.

11. Mixture as in claim 10, wherein the weight percentage of the conductive fibers in the mixture is between 0.1 and 20 %.

12. Method for producing an electrically conductive plastic product made via rotational moulding as in claim 1,
comprising the steps of
- providing a mixture as in any of the claims 10 or 11;
- introducing the mixture in a mould;
- perform a rotational moulding operation with the mould to convert the mixture into an electrically conductive plastic product.

## Patentansprüche

1. Elektrisch leitfähiges Kunststoffprodukt, das mittels Rotationsgießen hergestellt ist, umfassend
- eine Kunststoffmatrize; und
- ein Netz aus leitfähigen Fasern von diskreter Länge, das in die Kunststoffmatrize eingebettet ist, um dem Kunststoffprodukt elektrische Leitfähigkeit zu verleihen,
wobei die leitfähigen Fasern Metallfasern sind; und wobei die mittlere Länge der leitfähigen Fasern wenigstens 3 mm beträgt.

2. Elektrisch leitfähiges Kunststoffprodukt nach einem der vorstehenden Ansprüche, wobei die mittlere Länge der leitfähigen Fasern weniger als 25 mm beträgt.

3. Elektrisch leitfähiges Kunststoffprodukt nach einem der vorstehenden Ansprüche, wobei die Kunststoffmatrize eine Thermokunststoffmatrize ist.

4. Elektrisch leitfähiges Kunststoffprodukt nach einem der vorstehenden Ansprüche, wobei die Metallfasern von Metallfasern aus einer eisenhaltigen Legierung oder von Metallfasern aus einem nicht eisenhaltigen Metall bzw. einer solchen Legierung gebildet sind.

5. Elektrisch leitfähiges Kunststoffprodukt nach einem der Ansprüche 1 - 4, wobei die Metallfasern einen Querschnitt aufweisen, wobei der Querschnitt zwei benachbarte geradlinige Seiten mit einem eingeschlossenen Winkel von weniger als 90° und eine oder mehrere unregelmäßig geformte, gekrümmte Seiten aufweist.

6. Elektrisch leitfähiges Kunststoffprodukt nach Anspruch 1 - 4, wobei die Metallfasern einen nieren- oder bananenförmigen Querschnitt aufweisen.

7. Elektrisch leitfähiges Kunststoffprodukt nach einem der vorstehenden Ansprüche, wobei die Metallfasern einen Äquivalentdurchmesser von weniger als 100 µm aufweisen.

8. Elektrisch leitfähiges Kunststoffprodukt nach einem der vorstehenden Ansprüche, wobei die Metallfasern ein Länge-zu-Äquivalentdurchmesser-Verhältnis von weniger als 300 aufweisen.

9. Elektrisch leitfähiges Kunststoffprodukt nach einem der vorstehenden Ansprüche, wobei der Gewichtprozentanteil der leitfähigen Fasern im Kunststoffprodukt zwischen 0,1 und 20 % liegt.

10. Gemisch zum Einsatz beim Rotationsgießen des elektrisch leitfähigen Kunststoffprodukts,
wobei das Gemisch eine feste Dispersion aus leitfähigen Fasern von diskreter Länge in einem Kunststoffpulver umfasst;
wobei das Kunststoffpulver einen Durchmesser zwischen 0,2 und 0,7 mm aufweist;
wobei die leitfähigen Fasern Metallfasern sind und
wobei die leitfähigen Fasern eine mittlere Länge von wenigstens 3 mm aufweisen.

11. Gemisch nach Anspruch 10, wobei der Gewichtprozentanteil der leitfähigen Fasern im Gemisch zwischen 0,1 und 20 % liegt.

12. Verfahren zur Herstellung eines elektrisch leitfähigen Kunststoffprodukts mittels Rotationsgießen nach Anspruch 1,
die Schritte umfassend:
- Bereitstellen eines Gemischs nach einem der Ansprüche 10 oder 11;
- Einsetzen des Gemischs in eine Gießform;
- Durchführen des Rotationsgießvorgangs mit der Gießform, um das Gemisch in ein elektrisch leitfähiges Kunststoffprodukt umzuwandeln.

## Revendications

1. Produit en plastique électriquement conducteur fait par l'intermédiaire de moulage rotatif, comprenant
- une matrice de plastique ; et
- un réseau de fibres conductrices de longueur distincte encastrées dans la matrice de plastique pour fournir une conductivité électrique au produit en plastique, dans lequel les fibres conductrices sont des fibres de métal ; et
dans lequel la longueur moyenne des fibres conductrices est au moins 3 mm.

2. Produit en plastique électriquement conducteur selon l'une quelconque des revendications précédentes, dans lequel la longueur moyenne des fibres conductrices est inférieure à 25 mm.

3. Produit en plastique électriquement conducteur selon l'une quelconque des revendications précédentes, dans lequel la matrice de plastique est une matrice de thermoplastique.

4. Produit en plastique électriquement conducteur selon l'une quelconque des revendications précédentes, dans lequel les fibres de métal sont des fibres de métal faites d'un alliage ferreux, ou sont des fibres de métal faites d'un métal ou alliage non ferreux.

5. Produit en plastique électriquement conducteur selon l'une quelconque des revendications 1 à 4, dans lequel les fibres de métal ont une section transversale, dans lequel la section transversale a deux côtés revêtus droits voisins avec un angle inclus inférieur à 90° et un ou plusieurs côtés courbés de forme irrégulière.

6. Produit en plastique électriquement conducteur selon les revendications 1 à 4, dans lequel les fibres de métal ont une section transversale en forme de haricot ou de banane.

7. Produit en plastique électriquement conducteur selon l'une quelconque des revendications précédentes, dans lequel les fibres de métal ont un diamètre équivalent inférieur à 100 µm.

8. Produit en plastique électriquement conducteur selon l'une quelconque des revendications précédentes, dans lequel les fibres de métal ont un rapport longueur sur diamètre équivalent inférieur à 300.

9. Produit en plastique électriquement conducteur selon l'une quelconque des revendications précédentes, dans lequel le pourcentage en poids des fibres conductrices dans le produit en plastique est entre 0,1 et 20 %.

10. Mélange pour l'utilisation dans le moulage rotatif de produits en plastique électriquement conducteurs, dans lequel le mélange comprend une dispersion solide de fibres conductrices de longueur distincte dans une poudre de plastique ;
dans lequel la poudre de plastique a un diamètre entre 0,2 et 0,7 mm ;
dans lequel les fibres conductrices sont des fibres de métal, et
dans lequel les fibres conductrices ont une longueur moyenne d'au moins 3 mm.

11. Mélange selon la revendication 10, dans lequel le pourcentage en poids des fibres conductrices dans le mélange est entre 0,1 et 20 %.

12. Procédé pour produire un produit en plastique électriquement conductif fait par l'intermédiaire de moulage rotatif selon la revendication 1, comprenant les étapes de
- la fourniture d'un mélange selon l'une quelconque des revendications 10 ou 11 ;
- l'introduction du mélange dans un moule ;
- la réalisation d'une opération de moulage rotatif avec le moule pour convertir le mélange en un produit en plastique électriquement conducteur.
